# EUROPEAN PATENT APPLICATION

(11) **EP 4 460 156 A1**
(43) Date of publication of application: **06.11.2024**
(21) Application number: 22915928.0
(22) Date of filing: 22.12.2022
(51) Int. Cl.: H05K 1/09, H05K 1/11, H05K 3/40

(54) **WIRING BOARD**

(30) Priority: 28.12.2021 JP 2021215303
(71) Applicant: KYOCERA CORPORATION, Kyoto-shi, Kyoto 612-8501 (JP)
(72) Inventor: SANO, Hiroaki, Kyoto-shi, Kyoto 612-8501 (JP); HIGASHI, Toshifumi, Kyoto-shi, Kyoto 612-8501 (JP); IMOTO, Akira, Kyoto-shi, Kyoto 612-8501 (JP); YAMAGUCHI, Takafumi, Kyoto-shi, Kyoto 612-8501 (JP)
(74) Representative: Viering, Jentschura & Partner mbB Patent- und Rechtsanwälte
(86) International application number: PCT/JP2022/047494
(87) International publication number: WO 2023/127705

(57) **Abstract**

A wiring board includes an insulation layer, a via conductor, and a conductor layer. The insulation layer is made of a glass ceramic. The via conductor is disposed penetrating the insulation layer. The conductor layer is located in a direction along a surface of the insulation layer. The via conductor and the conductor layer are connected to each other, and are each a sintered body of a plurality of metal particles containing copper as a main component. An average particle diameter of the metal particles included in the via conductor is larger than the average particle diameter of the metal particles included in the conductor layer. The via conductor and the conductor layer in a cross-sectional view each contain 70% or more of a metal component per unit area.

## Description

### TECHNICAL FIELD

An embodiment of the present disclosure relates to a wiring board.

### BACKGROUND OF INVENTION

A wiring board including an insulation layer made of ceramic, a conductor layer containing copper as a main component, and a via conductor is known. Such a wiring board is obtained by, for example, simultaneously firing a conductor layer material and a via conductor material in which a metal oxide is added to copper powder, and a glass ceramic as an insulation layer material.

### CITATION LIST

### PATENT LITERATURE

Patent Document 1: JP 2003-277852 A
Patent Document 2: JP 2019-207977 A

### SUMMARY

A wiring board according to an aspect of an embodiment includes an insulation layer, a via conductor, and a conductor layer. The insulation layer is made of a glass ceramic. The via conductor is disposed penetrating the insulation layer. The conductor layer is located in a direction along a surface of the insulation layer. The via conductor and the conductor layer are connected to each other, and are each a sintered body of a plurality of metal particles containing copper as a main component. An average particle diameter of the metal particles included in the via conductor is larger than the average particle diameter of the metal particles included in the conductor layer. The via conductor and the conductor layer in a cross-sectional view each contain 70% or more of a metal component per unit area.

### BRIEF DESCRIPTION OF THE DRAWINGS

FIG. 1 is a cross-sectional view illustrating an example of a wiring board according to an embodiment.
FIG. 2 is an enlarged view of a region A illustrated in FIG. 1.
FIG. 3 is an explanatory diagram illustrating an evaluation method for crystallites.
FIG. 4 is an enlarged view of a region B illustrated in FIG. 1.
FIG. 5 is an enlarged view of a region C illustrated in FIG. 1.
FIG. 6 is a cross-sectional view schematically illustrating a sample according to an example.
FIG. 7 is a diagram showing evaluation results of the wiring boards according to the example.

### DESCRIPTION OF EMBODIMENTS

In the above-described wiring board, for example, an electrostatic capacitance of a capacitor formed between the conductor layers overlapping in the layering direction of the insulation layers may vary, and thus the wiring board has room for improvement. The capacitor formed between the conductor layers overlapping in the layering direction of the insulation layers may be hereinafter referred to as a built-in capacitor.

It is expected to provide a wiring board in which a variation in electrostatic capacitance of a built-in capacitor is small.

Hereinafter, embodiments of a wiring board disclosed in the present application will be described with reference to the accompanying drawings. The present disclosure is not limited by the following embodiments.

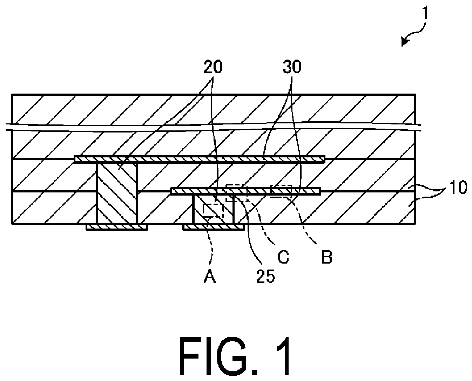

FIG. 1 is a cross-sectional view illustrating an example of a wiring board according to an embodiment. As illustrated in FIG. 1, a wiring board 1 according to the embodiment includes an insulation layer 10, a via conductor 20, and a conductor layer 30.

The insulation layer 10 is made of a glass ceramic. Thus, the wiring board 1 can be manufactured by simultaneously firing a green sheet, which is the material of the insulation layer 10, and the conductive paste containing the metal particles, which is the material of the via conductor 20 and the conductor layer 30.

The via conductor 20 has conductivity and is disposed penetrating the insulation layer 10.

The via conductor 20 contains copper as a main component. Specifically, the via conductor 20 contains 50 mass% or more of copper. The via conductor 20 may contain 70 mass% or more of copper.

The via conductor 20 is a sintered body of a plurality of metal particles containing copper as a main component. The via conductor 20 includes a crystallite 2 having a polygonal shape in a cross-sectional view. The state in which the via conductor 20 includes the polygonal crystallite 2 can be confirmed by analysis using an electron back scattered diffraction (EBSD) pattern method.

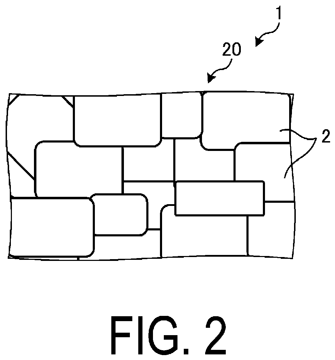

FIG. 2 is an enlarged view of a region A illustrated in FIG. 1. The via conductor 20 has a structure of two groups of crystallites as schematically illustrated in FIG. 2. In this case, in the via conductor 20, a plurality of adjacent crystallites 2 may be in contact with each other with a linear side of each crystallite 2 as a grain boundary. The via conductor 20 has a crystal structure in which the crystallites 2 are in contact with each other at their linear sides. In the crystallite 2 included in the via conductor 20, the contact area between the crystallites 2 is large as compared with the case where the crystallite 2 has a spherical shape or a particle shape close to a spherical shape. As a result, the interface conductivity at a high frequency can be increased, so that a wiring board having a high interface conductivity at a high frequency can be obtained.

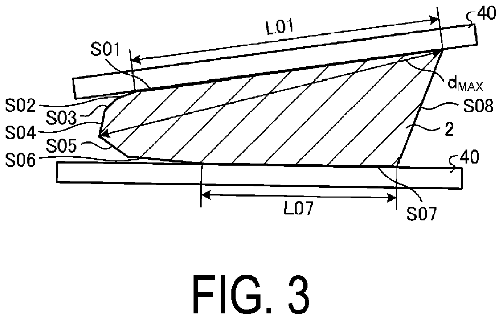

Here, a method for evaluating the "linear side" of the crystallite 2 will be described with reference to FIG. 3. FIG. 3 is an explanatory diagram illustrating an evaluation method for crystallites. As illustrated in FIG. 3, the crystallite 2 has a polygonal cross section. As an example, the crystallite 2 illustrated in FIG. 3 has an octagonal contour having sides S01 to S08. For example, a scale (or ruler) 40 is prepared and located along the side S01 in the captured image of the via conductor 20 including such a cross section. The side S01 is defined as a "linear side" when a portion of the side S01 extending along the scale (or ruler) 40 is equal to or longer than a half of the longest diameter d_{MAX} of the crystallite 2. For each of the other sides S02 to S08, whether the side is a "linear side" is evaluated in the same way as the side S01. In the example illustrated in FIG. 3, the side S01 having a length L01 and the side S07 having a length L07 are evaluated as "linear sides". That is, the crystallite 2 illustrated in FIG. 3 has two "linear sides". The longest diameter d_{MAX} of the crystallite 2 may be 1 µm or more and 10 µm or less.

For example, for the via conductor 20 according to the embodiment, the above-described evaluation is repeated for each side of each of the plurality of crystallites 2. In such a case, the plurality of crystallites 2 may include 50% or more of crystallites 2 having two or more linear sides. As described above, in the wiring board 1 including the via conductor 20 in which 50% or more of the crystallites 2 have two or more linear sides, for example, a decrease in the interface conductivity at frequencies of 1 GHz to 49 GHz can be reduced. Accordingly, interface conductivity at high frequencies can be enhanced.

In this case, the wiring board 1 is cut at a position where the cross section of the via conductor 20 can be seen, and the cut surface is polished to prepare a sample for observing the cross section.

The polished surface is analyzed using the EBSD method. The imaging range of the sample in the thickness direction and the length direction of the via conductor 20 is set as follows, for example. The number of crystallites 2 included in the imaging range is, for example, 50 or more and 100 or less.

A range of about 20 µm in the thickness direction and the width direction of the via conductor 20 is imaged. A range of 10 µm or more to 20 µm or less in the thickness direction and the width direction of the via conductor 20 may be imaged.

Returning to FIG. 1, further description will be given. The conductor layer 30 has conductivity and is disposed in a predetermined pattern shape on the surface of the insulation layer 10 and between the insulation layers 10 adjacent to each other. That is, in the wiring board 1, the conductor layer 30 is located in a direction along the surface of the insulation layer 10. The conductor layers 30 are located at predetermined intervals with the insulation layer 10 interposed therebetween. When two conductor layers 30 are arranged at such a position that one insulation layer 10 is sandwiched between the conductor layers 30, a portion where the two conductor layers 30 overlap each other via the one insulation layer 10 in the arrangement is a portion that functions as a capacitor. In other words, in the wiring board 1, a portion that functions as a capacitor is a portion where two conductor layers 30 with which one insulation layer 10 is sandwiched overlap each other.

The conductor layer 30 contains copper as a main component. Specifically, the conductor layer 30 contains 50 mass% or more of copper. The conductor layer 30 may contain 70 mass% or more of copper.

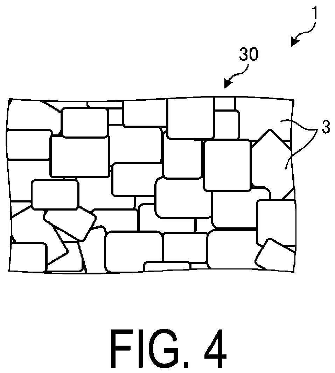

Similarly to the via conductor 20, the conductor layer 30 is a sintered body of a plurality of metal particles containing copper as a main component. FIG. 4 is an enlarged view of a region B illustrated in FIG. 1. As illustrated in FIG. 4, the conductor layer 30 may also include a crystallite 3 having a polygonal shape in a cross-sectional view.

Also in this case, in the conductor layer 30, a plurality of adjacent crystallites 3 may be in contact with each other with the linear side of each crystallite 3 as a grain boundary. The plurality of crystallites 3 may include 50% or more of crystallites 3 having two or more linear sides. As a result, the interface conductivity at a high frequency can be increased, so that a wiring board exhibiting a high interface conductivity at a high frequency can be obtained.

In the wiring board 1 according to the embodiment, the average particle diameter of the metal particles included in the via conductor 20 may be larger than the average particle diameter of the metal particles included in the conductor layer 30. Specifically, for example, by setting the average particle diameter of the metal particles included in the via conductor 20 and the average particle diameter of the metal particles included in the conductor layer 30 to 6.6:1 to 1.4:1, particularly 5:1 to 1.3:1, the wiring board 1 having high performance is obtained. In other words, when the average particle diameter of the crystallites 2 included in the conductor layer 30 is set to 1, the average particle diameter of the crystallites 2 included in the via conductor 20 is, for example, in a range of 1.4 times or more and 6.6 times or less, and particularly, may be in a range of 1.3 times or more and 5 times or less.

Here, a method for obtaining the average particle diameter of the crystallites 2 included in the via conductor 20 will be described. First, the obtained wiring board 1 is cut or polished to produce a sample in which the cross section of the via conductor 20 is exposed. The cross section of the wiring board 1 including the cross section of the via conductor 20 is preferably finished to a mirror surface level. The cross section of the via conductor 20 is observed by using the EBSD method, and the image of the cross section is captured. The following measurements are performed using the image captured. In the cross section of the via conductor 20, for example, one region where 20 or more and 30 or less crystallites 2 are included is specified. The shape of the specified range is preferably circular or quadrangular. Image analysis is then performed on each crystallite 2 present in the specified place, and the area of the crystallite 2 is obtained. Next, an area obtained by converting the obtained area into a circle is obtained. The diameter is then determined from the area converted into a circle. The diameter thus obtained is defined as the particle diameter of each crystallite 2. Such measurement is performed on the crystallites 2 present in the specified place, and the average particle diameter is obtained. In addition to the polygonal crystallites 2, other crystallites 2, for example, spherical crystallites 2 may be included in the specified place. The average particle diameters of the crystallites 2 in the conductor layer 30 and the connection portion between the via conductor 20 and the conductor layer 30 are also obtained by the same method or a similar method. When a voltage is applied to the wiring board 1, the via conductor 20 and the conductor layer 30 are electrically connected to each other.

The via conductor 20 and the conductor layer 30 in a cross-sectional view may contain 70% or more of a metal component per unit area. As a result, the metal components of the via conductor 20 and the conductor layer 30 are densified, and the wiring board 1 having high performance is obtained. The ratio of the metal component contained in each of the via conductor 20 and the conductor layer 30 may also be evaluated by observing and imaging a place the same as or similar to the place of the cross-sectional image used for obtaining the average particle diameter of the crystallite 2, with an electron microscope. An area A1 of voids is obtained by image analysis from images obtained by imaging cross sections of the via conductor 20 and the conductor layer 30, and a ratio of (A0 - A1)/A0 is obtained when an area of a specified range is defined as a total area A0.

The via conductor 20 and the conductor layer 30 may contain silica. The silica may have, for example, an average particle diameter of 10 nm or more and 30 nm or less. The silica may be contained at a ratio of 0.3 parts by mass or more and 0.8 parts by mass or less with respect to 100 parts by mass of Cu. In the case where the via conductor 20, the conductor layer 30, and the conductive paste for forming these contain a glass component other than silica, the content of silica is preferably less than the content of the glass component other than silica.

The via conductor 20 and the conductor layer 30 may contain borosilicate glass. The silica may have, for example, an average particle diameter of 50 nm or more and 200 nm or less. The borosilicate glass may be contained at a ratio of about 1 part by mass with respect to 100 parts by mass of Cu.

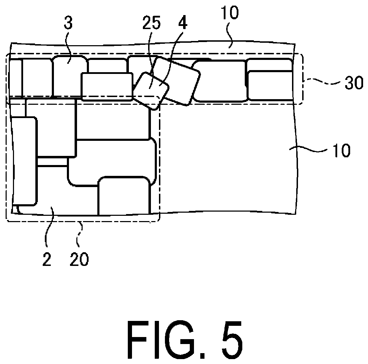

As illustrated in FIG. 1, the wiring board 1 may include a connection portion 25. The connection portion 25 refers to a portion where the end portion of the via conductor 20 and the conductor layer 30 are in contact with each other. FIG. 5 is an enlarged view of a region C illustrated in FIG. 1. As illustrated in FIG. 5, the connection portion 25 may include a crystallite 4 having a particle diameter smaller than the average particle diameters of the crystallites 2 and 3 included in the via conductor 20 and the conductor layer 30, respectively. Thus, the connection portion 25 is densified, and the adhesion between the via conductor 20 and the conductor layer 30 is increased. The connection portion 25 may include one or more such crystallites 4.

### Examples

Samples No. 1 to No. 24 simulating the wiring board 1 according to the embodiment were produced, and the deviations of the capacitor capacitances were evaluated.

First, a mixture of 40 wt.% alumina particles and 60 wt.% borosilicate glass was prepared as the material of the insulation layer 10. The mixture is a glass ceramic raw material having a firing temperature of 900°C or higher and 1000°C or lower. As an organic binder, 20 parts by mass of isobutyl methacrylate resin and dibutyl phthalate were used with respect to 100 parts by mass of the glass ceramic raw material, and a green sheet having a thickness of 100 µm was produced by doctor blade molding.

As raw materials for the via conductors 20 and the conductor layers 30, copper powders having different average particle diameters depending on the samples, silica particles having an average particle diameter of 20 nm, and borosilicate glass particles having an average particle diameter of 100 nm were prepared. The silica particles have a percentage of the integrated amount of the lower limit of 10 nm and the upper limit of 30 nm of 70% or more. As the organic binder, isobutyl methacrylate resin and a mixed solvent of butyl carbitol acetate and dibutyl phthalate were used. A conductive paste containing 100 parts by mass of copper powder, 0.3 parts by mass of silica particles, and 1 part by mass of borosilicate glass particles was prepared by adding 5 parts by mass of isobutyl methacrylate resin to 100 parts by mass of copper powder and further adding a mixed solvent of butyl carbitol acetate and dibutyl phthalate. For Samples No. 6, 12, 18, and 24, conductive pastes containing 100 parts by mass of copper powder and 1 part by mass of borosilicate glass particles were prepared.

A conductive paste having a substantially columnar shape was printed so as to penetrate the prepared green sheet, and the conductive paste was printed on both surfaces of the green sheet in a predetermined area to prepare a laminate, and the laminate was fired. Firing was performed in a reducing atmosphere using a nitrogen-hydrogen mixed gas at a maximum temperature of 930°C for a holding time of 2 hours. As the laminate, a laminate in which two insulation layers 10 each having a thickness of 35 µm and 13 insulation layers 10 each having a thickness of 25 µm were layered to form 15 layers was used.

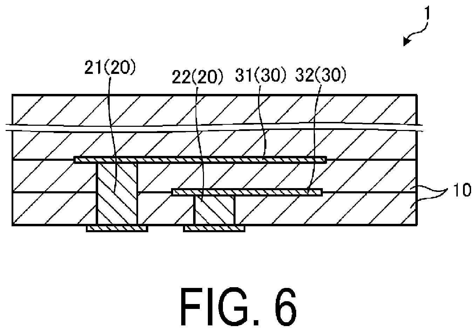

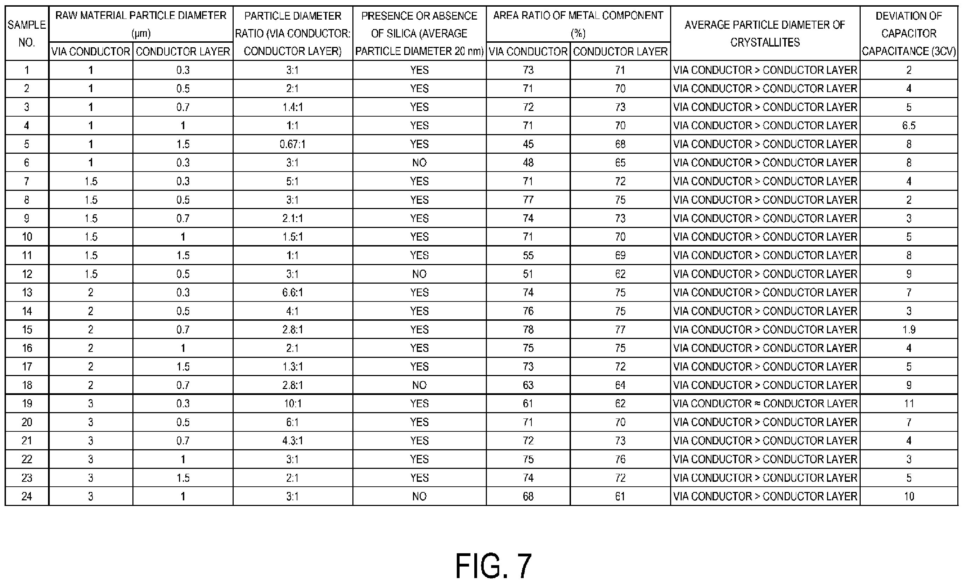

FIG. 6 is a cross-sectional view schematically illustrating a sample according to an example. As the wiring board 1 as a sample according to the example, a wiring board in which two insulation layers 10 each having a thickness of 35 µm and 13 insulation layers 10 each having a thickness of 25 µm were layered to form 15 layers was used. The evaluation layer corresponding to the interval between the conductor layer 31 electrically connected to the via conductor 21 and the conductor layer 32 electrically connected to the via conductor 22 was set to 25 µm, a predetermined voltage was applied between the via conductor 21 and the via conductor 22, and the electrostatic capacitance (capacitor capacitance) between the conductor layers 31, 32 was measured. This measurement was performed at 30 points, and the deviation (variation coefficient 3CV: 3 × standard deviation (σ)/average value (x)) was calculated. The results are shown in FIG. 7.

FIG. 7 is a diagram illustrating evaluation results of the wiring boards according to the example. FIG. 7 shows the average particle diameters (raw material particle diameters) of the copper powders as raw materials of the via conductors 20 and the conductor layers 30, the ratios (particle diameter ratios) of the average particle diameters of the copper powders as raw materials of the via conductors 20 and the conductor layers 30, the presence or absence of the silica particles in the conductive paste, the contents of the metal components per unit area in the via conductors 20 and the conductor layers 30 in cross-sectional view (area ratios of the metal components), the comparison of the average particle diameters of the crystallites in the via conductors 20 and the conductor layers 30, and the deviations (3CV) of the capacitor capacitances. As a result of the analysis using the EBSD method, the average particle diameters of the crystallites were each a value corresponding to the raw material particle diameter except for Sample No. 19.

As shown in FIG. 7, in the wiring boards of Sample No. 1 to 4, 7 to 10, 13 to 17, and 20 to 23, the 3CV was as small as 7 or less, and high-performance wiring boards were obtained. In particular, in the wiring boards according to Sample No. 1 to 3, 7 to 10, 14 to 17, and 21 to 23, the 3CV was as small as 5 or less, and the wiring boards having extremely high performance were obtained.

On the other hand, in the case of the wiring boards of Sample No. 5 and 11, the 3CV was more than 7, and the wiring boards having low performance were obtained. Presumably, this is partly because the raw material particle diameter in the via conductor 20 is equal to or less than the raw material particle diameter in the conductor layer 30.

The wiring board of Sample No. 19 also had a 3CV of more than 7, and the wiring board having low performance was obtained. One of the reasons is presumably that the raw material particle diameter in the via conductor 20 was excessively larger than the raw material particle diameter in the conductor layer 30 and that the average particle diameters of the crystallites in the via conductor 20 and the conductor layer 30 became substantially equal to each other due to the grain growth. In Sample No. 19, since the difference in the particle diameter was large, the copper particles having a smaller particle diameter grew to a size corresponding to the particle diameter of the copper particles having a larger particle diameter. In Sample No. 19, a portion in which the coverage of the conductor layer 30 was low was observed, and the electrostatic capacitance was about 30% of the other samples.

The wiring boards of Samples No. 6, No. 12, No. 18, and No. 24 each had a capacitor capacitance deviation (3CV) of more than 7, and the wiring boards having low performances were obtained. One of the reasons is presumably that silica particles having an average particle diameter smaller than that of borosilicate glass particles are not contained.

Among the prepared samples, each of the via conductor and the conductor layer to which the silica particles were added contained polygonal crystallites at a ratio in a range of 50% to 80%. In all of these samples, crystallites having a particle diameter smaller than the average particle diameter of the crystallites included in the via conductor and the conductor layer were observed in the connection portion where the end portion of the via conductor and the conductor layer were in contact with each other.

Additional effects and other aspects can be easily derived by a person skilled in the art. Thus, a wide variety of aspects of the present disclosure are not limited to the specific details and representative embodiments represented and described above. Accordingly, various changes are possible without departing from the spirit or scope of the general inventive concepts defined by the appended claims and their equivalents.

### REFERENCE SIGNS

1 Wiring board
2 to 4 Crystallite
10 Insulation layer
20 Via conductor
30 Conductor layer

## Claims

1. A wiring board comprising:
an insulation layer;
a via conductor; and
a conductor layer, wherein
the insulation layer is made of a glass ceramic,
the via conductor is disposed penetrating the insulation layer,
the conductor layer is located in a direction along a surface of the insulation layer,
the via conductor and the conductor layer are connected to each other, and are each a sintered body of a plurality of metal particles containing copper as a main component,
an average particle diameter of the metal particles comprised in the via conductor is larger than an average particle diameter of the metal particles comprised in the conductor layer, and
the via conductor and the conductor layer in a cross-sectional view each contain 70% or more of a metal component per unit area.

2. The wiring board according to claim 1, wherein
the metal particles comprised in the via conductor and the conductor layer comprise a plurality of crystallites, and
the plurality of crystallites comprise a polygonal crystallite comprising a side that is linear, and are in contact with the side as a grain boundary.

3. The wiring board according to claim 2, wherein
the plurality of crystallites comprise 50% or more of crystallites having two or more of the sides that are linear in terms of number ratio per unit area.

4. The wiring board according to claim 1 or 2, wherein
a connection portion in which an end portion of the via conductor and the conductor layer are in contact with each other comprises a crystallite having a particle diameter smaller than an average particle diameter of the crystallites comprised in the via conductor and the conductor layer.

5. The wiring board according to any one of claims 1 to 4, wherein
the via conductor and the conductor layer contain silica.
